(19) Europäisches Patentamt / European Patent Office / Office européen des brevets

(11) **EP 3 407 394 A1**

(12) **EUROPEAN PATENT APPLICATION**
published in accordance with Art. 153(4) EPC

(43) Date of publication:
**28.11.2018 Bulletin 2018/48**

(51) Int Cl.:
*H01L 33/22* (2010.01)      *C30B 25/04* (2006.01)
*H01L 21/203* (2006.01)      *H01L 21/205* (2006.01)

(21) Application number: **17741446.3**

(22) Date of filing: **18.01.2017**

(86) International application number:
**PCT/JP2017/001601**

(87) International publication number:
**WO 2017/126569 (27.07.2017 Gazette 2017/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **22.01.2016 JP 2016010887**

(71) Applicant: **Oji Holdings Corporation**
**Chuo-ku**
**Tokyo 104-0061 (JP)**

(72) Inventors:
• **DAI, Kotaro**
**Tokyo 104-0061 (JP)**
• **SHINOTSUKA, Kei**
**Tokyo 104-0061 (JP)**
• **HATTA, Yoshihisa**
**Tokyo 104-0061 (JP)**

(74) Representative: **Patentanwälte Bals & Vogel**
**Universitätsstrasse 142**
**44799 Bochum (DE)**

(54) **SEMICONDUCTOR LIGHT-EMITTING ELEMENT SUBSTRATE, AND METHOD FOR MANUFACTURING SEMICONDUCTOR LIGHT-EMITTING ELEMENT SUBSTRATE**

(57)      The semiconductor light-emitting element substrate is provided with: a reference surface which includes a flat surface parallel to a crystal plane of the material of the semiconductor light-emitting element substrate; and a plurality of protrusions which protrude from the reference surface, the protrusions being arranged on a two-dimensional lattice along the crystal plane and including a flat surface parallel with the crystal plane as a distal face. In a plane including the reference surface, mutually adjacent protrusions have a pitch P of not less than 100 nm and not more than 5.0 $\mu$m, wherein 0.76 $\leq$ S1/S2 $\leq$ 7.42 is satisfied, where S1 is a first area which is the total area of the distal faces per unit area as viewed in plan opposing the reference surface, and S2 is a second area which is the total area of the reference surface per unit area.

Fig.2

## Description

Technical Field

The technology of the present disclosure relates to a semiconductor light-emitting element substrate having a face for growing a crystal layer of a compound semiconductor, the face including a plurality of convexities, and a method for manufacturing the semiconductor light-emitting element substrate.

Background Art

A semiconductor light-emitting element used for a light-emitting diode or the like includes a semiconductor light-emitting element substrate having a target face parallel to a crystal plane, and a light-emitting device disposed on the target face. For example, a material constituting the semiconductor light-emitting element substrate is sapphire or silicon carbide. The light-emitting device is, for example, a multi-layered body of III-V semiconductor thin films. When an electric current is supplied to the light-emitting device, the light-emitting device emits light, and the emitted light is extracted to the outside of the semiconductor light-emitting element. As a technology for enhancing the light extraction efficiency from the semiconductor light-emitting element at that time, for example, a technology for reducing attenuation of light in the light-emitting device by geometrical reflection and refraction due to a recessing and protruding structure provided on the target face is also known (for example, see Patent Literatures 1 to 3).

Citation List

Patent Literature

    Patent Literature 1: JP 2002-280611 A
    Patent Literature 2: JP 2003-318441 A
    Patent Literature 3: JP 2012-248874 A

Summary of Invention

Technical Problem

A compound semiconductor layer constituting the light-emitting device includes some defects such as crystal dislocation. In the compound semiconductor layer in which the light-emitting intensity greatly depends on crystallinity, a defect included in the compound semiconductor layer affects electronic properties and optical properties, reducing the light-emitting efficiency in the light-emitting device.

The target face of the semiconductor light-emitting element substrate includes a crystal plane in a material forming the semiconductor light-emitting element substrate, and has a function for growing a crystal layer of a compound semiconductor in a method for forming the compound semiconductor layer. The crystal dislocation density in the compound semiconductor layer varies depending on a process of crystal layer growth on the target face. In the technology disclosed in Patent Literature 1, a plurality of convexities are provided on the target face of the semiconductor light-emitting element substrate, and the area of the convexities in a unit area of the target face is set to be sufficiently small. Thus, an increase in crystal dislocation density due to the convexities is suppressed.

However, in the technology for setting the area of the convexities in the unit area to be sufficiently small, it is necessary that a position where the layer growth of the compound semiconductor starts is a gap between the convexities adjacent to each other. Therefore, in a process of growth in which the position where the layer growth of the compound semiconductor starts is not the gap, there is still room for improvement. In particular, in formation of a layer of a compound semiconductor having high interaction between crystals thereof, such as aluminum nitride, a crystal nucleus of the compound semiconductor does not possess a sufficient mobility. Specifically, a crystal nucleus of the compound semiconductor attached to an end face or a side of the convexity remains on a surface of the convexity without moving to a concavity that is a gap between the convexities adjacent to each other. As a result, the layer growth of the compound semiconductor starts from the end face or side of the convexity.

A semiconductor light-emitting element substrate that enables reduction in the crystal dislocation density in a compound semiconductor layer, and a method for manufacturing such a semiconductor light-emitting element substrate are provided.

Solution to Problem

A semiconductor light-emitting element substrate for solving the problems includes a reference plane including a flat face parallel to a crystal plane of a material constituting the semiconductor light-emitting element substrate, and a plurality of convexities that are projected from the reference plane and arranged on two-dimensional lattices along the crystal plane and a convexity within the plurality of convexities has a flat face parallel to the crystal plane as an end face. The plurality of convexities adjacent to each other are disposed on a plane including the reference plane at a pitch P from 100 nm to 5.0 μm, and a relationship $0.76 \leq S1/S2 \leq 7.42$ is satisfied where a first area S1 is a total area of a plurality of the end faces in a unit area in a plan view facing toward the reference plane, and a second area S2 is a total area of the reference plane in the unit area.

A method for manufacturing a semiconductor light-emitting element substrate for solving the problems includes forming a mask on a treatment face that is a flat face parallel to a crystal plane of a material constituting the substrate and is included in the substrate; and forming a plurality of convexities and a reference plane on the substrate by etching the treatment face using the mask. A convexity within the plurality of convexities has a flat face as an end face, and the flat surface is a portion of the treatment face covered with the mask. The plurality of convexities are arranged on a two-dimensional lattice along the crystal plane. The reference plane is a bottom face in a concavity that is a gap between the convexities adjacent to each other and includes a flat face parallel to the crystal plane. The plurality of convexities adjacent to each other are disposed on a plane including the reference plane at a pitch P from 100 nm to 5.0 $\mu$m. In the formation of the plurality of convexities and the reference plane, a relationship $0.76 \leq S1/S2 \leq 7.42$ is satisfied where a first area S1 is a total area of a plurality of the end faces in a unit area in a plan view facing toward the reference plane, and a second area S2 is a total area of the reference plane in the unit area.

According to the semiconductor light-emitting element substrate and the method for manufacturing the same, in a case where the total area S1 of the end faces of the convexities is larger than the total area S2 of the reference plane, a probability in which a crystal nucleus reaches the end face of the convexity in formation of layer of a compound semiconductor is higher than a probability in which the crystal nucleus reaches the reference plane that is the gap between the convexities adjacent to each other. In a case where the nucleus has such a mobility that the nucleus that has reached the end faces of the convexities cannot move to the reference plane, the layer growth of the compound semiconductor is more likely to start on the end face of the convexity than on the reference plane. The crystal layer of the compound semiconductor layer that has already grown from the end face of the convexity prevents the crystal nucleus of the compound semiconductor from reaching the reference plane that is a gap between the convexities. On the other hand, even in the case where the total area S1 of the end faces of the convexities is smaller than the total area S2 of the reference plane, the effect described below is obtained as long as S1 and S2 satisfy the relationship, $0.76 \leq S1/S2$, in a case where the end face has an area that allows the crystal nucleus to remain on the end face or an area that allows the crystal nucleus to grow. That is, coalescence between the crystal layer of the compound semiconductor layer grown from the end face of the convexity and the crystal layer of the compound semiconductor layer grown from the reference plane is suppressed, and a continuous compound semiconductor layer is formed due to coalescence growth of the crystal layers that have grown from the end faces of the convexities adjacent to each other. Therefore, the crystal dislocation density in the compound semiconductor layer can be reduced.

In a case where the semiconductor light-emitting element substrate has a configuration in which a side that allows the crystal layer of the compound semiconductor layer to grow is a simple flat face parallel to the crystal plane, that is, a side where the convexities projected from the reference plane is absent, a position of the crystal layer constituting the compound semiconductor layer is irregularly distributed over the entire side. In the semiconductor light-emitting element substrate described above, the repeating pitch between the convexities is from 100 nm to 5.0 $\mu$m, and thus irregular arrangement of position of the crystal layer constituting the compound semiconductor layer is suppressed. Furthermore, irregular distribution of crystal dislocation density can be suppressed due to the coalescence growth of the crystal layer.

In the semiconductor light-emitting element substrate, the end width Lb that is the maximum width of the end face in a direction parallel to the end face, and the pitch P may satisfy a relationship $0.50 \leq Lb/P \leq 0.88$.

According to the semiconductor light-emitting element substrate described above, such a relationship may prevent the plurality of the convexities from including a convexity having an excessively small end width Lb, and a convexity having an excessively large end width Lb. Therefore, the effect of reducing the crystal dislocation density may be obtained more readily.

In the semiconductor light-emitting element substrate described above, a maximum width of a base of the convexity in a direction parallel to the end face is a base width La, and a distance between the base and the end face in a projection direction of the convexity is a convexity height H, and La and H may satisfy a relationship $0.01 \leq H/La \leq 1.0$. From the viewpoint of enhancing reproducibility of a shape of the convexities in processing of the convexities, a relationship $0.1 \leq H/La \leq 1.0$ is preferably satisfied in a case where the pitch is less than 1.0 $\mu$m.

According to the semiconductor light-emitting element substrate described above, an aspect ratio H/La, which is a quotient of the convexity height H divided by the base width La, is not less than 0.01. The coalescence of the crystal layer of the compound semiconductor layer grown from the end face of the convexity and the crystal layer of the compound semiconductor layer grown from the reference plane is suppressed with more certainty. Since the aspect ratio H/La is not greater than 1.0, a load on processing in which the convexity height H is set to an unnecessarily large value or the second area S2 is set to an unnecessarily small value is also suppressed.

In the semiconductor light-emitting element substrate described above, the convexity may have a frustum shape.

According to the semiconductor light-emitting element substrate described above, a region where the reference plane supporting the convexity is connected to the base of the convexity can be larger compared with a case where the convexity has a columnar or inverted frustum shape. Therefore, the convexity can be structurally stabilized.

In the semiconductor light-emitting element substrate described above, the forming the mask may be forming the mask by forming a particle monolayer in which a plurality of fine particles are arranged in layers on the treatment face.

According to the method for manufacturing the semiconductor light-emitting element substrate described above, exposure for forming the mask and development for forming the mask can be omitted from a manufacturing process. Thus, the number of treatment steps for the substrate can be reduced.

Advantageous Effects of Invention

According to an embodiment of the present invention, the crystal dislocation density in the compound semiconductor layer can be reduced.

Brief Description of Drawings

FIG. 1 is a plan view of a planar structure of a semiconductor light-emitting element substrate in one embodiment embodying a semiconductor light-emitting element substrate.

FIG. 2 is a plan view of a planar structure of a semiconductor light-emitting element substrate in the embodiment embodying a semiconductor light-emitting element substrate. In the planar structure, end faces and bottom faces are hatched in different manners.

FIG 3 is a cross-sectional view illustrating a cross-sectional structure of a semiconductor light-emitting element substrate, the cross-section taken along the line 2-2, in the embodiment embodying a semiconductor light-emitting element substrate.

FIG. 4 is a view illustrating a step of forming a mask used in a manufacturing method by using a cross-sectional structure of a substrate in one embodiment embodying a method for manufacturing a semiconductor light-emitting element substrate.

FIG. 5 is a view illustrating a state of a substrate in an etching step in a manufacturing method by using a cross-sectional structure of the substrate in the embodiment embodying a method for manufacturing a semiconductor light-emitting element substrate.

FIG. 6 is a view illustrating the state of the substrate after completion of the etching step in the manufacturing method by using the cross-sectional structure of the substrate in the embodiment embodying the method for manufacturing a semiconductor light-emitting element substrate.

FIG. 7 is a view illustrating a process of forming a compound semiconductor layer on a semiconductor light-emitting element substrate in one embodiment by using a cross-sectional structure of the semiconductor light-emitting element substrate.

FIG. 8 is a view illustrating a state in which the compound semiconductor layer is formed on the semiconductor light-emitting element substrate in the embodiment by using the cross-sectional structure of the semiconductor light-emitting element substrate.

Description of Embodiments

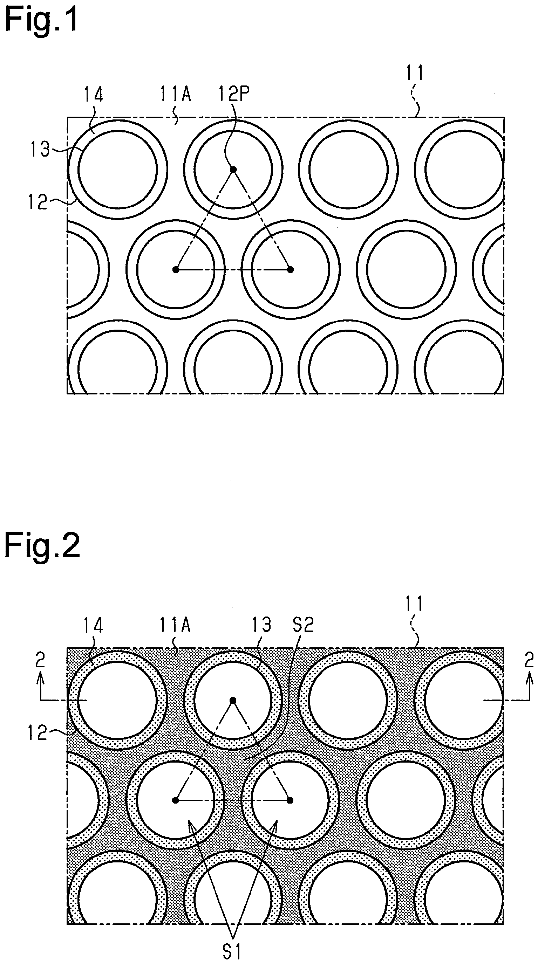

Embodiments embodying a semiconductor light-emitting element substrate and a method for manufacturing the semiconductor light-emitting element substrate will be described with reference to FIGS. 1 to 8.

Semiconductor Light-Emitting Element Substrate

As illustrated in FIG. 1, one face of a semiconductor light-emitting element substrate 11 is a recessing and protruding face that is a target of formation of a compound semiconductor layer, and includes a reference plane 11A and a plurality of convexities 12 projected from the reference plane 11A. The reference plane 11A is a portion in one face of the semiconductor light-emitting element substrate 11, and the portion is other than a portion occupied by the convexities 12. The compound semiconductor layer is formed by crystal layer growth of a compound semiconductor from the recessing and protruding face.

The reference plane 11A, at least partially, includes a flat face parallel to a crystal plane of a material constituting the semiconductor light-emitting element substrate 11. The plurality of convexities 12 are arranged along the crystal plane, and a convexity within the plurality of convexities 12 include an end face 13 that is a flat face parallel to the crystal plane and a circumferential face 14 that is a tubular face joining a circumference of the end face 13 to the reference plane 11A. For the reference plane 11A, the entire reference plane 11A may be one crystal plane, or a portion of the reference plane 11A may be one crystal plane. Substantially all of the end faces 13 form one crystal plane, and the occupancy of one crystal plane in the end faces 13 is sufficiently larger than the occupancy of one crystal plane in the reference plane 11A.

FIG. 1 illustrates an example of arrangement in which centers 12P of the end faces 13 in the plan view facing toward the reference plane 11A are positioned at vertexes of triangular lattice. In an aspect of arrangement of the plurality of convexities 12, for example, the centers 12P of the end faces 13 may be positioned at vertexes of tetragonal lattice or at vertexes of triangular lattice. That is, in the aspect of arrangement of the plurality of convexities 12, the end faces 13 are positioned at lattice points of a two-dimensional lattice. Specifically, in the aspect of arrangement of the plurality of convexities 12, the end faces 13 parallel to the crystal plane have a periodicity, and the plurality of end faces 13 are arranged on a plurality of lattice points of the two-dimensional lattice. The recessing and protruding face of the semiconductor light-emitting element substrate 11 may include a plurality of groups that are each formed by the plurality of end faces 13 periodically arranged.

FIG. 1 further illustrates an example in which a base of convexity 12 is connected to the reference plane 11A and the shape of convexity 12 is a truncated cone, which becomes narrower from the base toward the end. The shapes of the convexities 12 may be the same as each other or different from each other. The shapes of the plurality of convexities 12 may be a truncated cone, a truncated pyramid, an inverted truncated cone, an inverted truncated pyramid, a cylinder, a polygonal column, a multistage column that becomes narrower from the base toward the end, or a combination of two or more selected from the shapes.

The material constituting the semiconductor light-emitting element substrate 11 has thermal, mechanical, chemical, and optical resistances in a process of manufacturing a semiconductor light-emitting element. The material constituting the semiconductor light-emitting element substrate 11 is, for example, one selected from the group consisting of $Al_2O_3$, SiC, Si, SiGe, $MgAl_2O_4$, $LiTaO_3$, $LiNbO_3$, $ZrB_2$, GaP, GaN, GaAs, InP, InSn, AIN, and $CrB_2$. The material constituting the semiconductor light-emitting element substrate 11 is preferably $Al_2O_3$ from the viewpoints that it has high mechanical, thermal, chemical, and optical resistances, optical transparency, an advantage in terms of price, and high supply amount among these materials.

The crystal plane included in the reference plane 11A and the crystal plane constituting the end faces 13 have Miller indices that are the same as each other. In formation of the compound semiconductor layer, the compound semiconductor layer that grows from each of the end faces 13 is a crystal layer 31K constituting one compound semiconductor layer. The crystal plane constituting each of the end faces 13 has a function of imparting common crystallinity to the crystal plane 31 that grows from each of the end faces 13.

For example, when a crystal system of the semiconductor light-emitting element substrate 11 is a hexagonal crystal system, the crystal plane included in the reference plane 11A and/or the end faces 13 is one selected from the group consisting of a c-plane, a m-plane, an a-plane, and a r-plane. For example, in a case where the crystal system of the semiconductor light-emitting element substrate 11 is a cubic crystal system, the crystal plane included in the reference plane 11A and/or the end faces 13 is one selected from the group consisting of a (001) face, a (111) face, and a (110) face. The Miller indices of the crystal plane included in the reference plane 11A and the crystal plane constituting the end faces 13 may be higher than the Miller indices described above.

As illustrated in FIG. 2, the recessing and protruding face of the semiconductor light-emitting element substrate 11 includes the end faces 13 represented by white circles, a circumferential face 14 having a toric shape surrounding each of the end faces 13, represented by light dots, and the reference plane 11A that occupies the outside of each of the circumferential faces 14 and is represented by dense dots, as viewed in a direction facing toward the reference plane 11A.

A region that occupies a structure of minimum repeated unit as viewed in the direction facing toward the reference plane 11A is a unit region, and the area of the unit region, that is, the area that occupies a triangular unit lattice in an example illustrated in FIG. 2 is a unit area. The unit region that defines the unit area may be a region repeated in the recessing and protruding face of the semiconductor light-emitting element substrate 11, for example, a region including at least one of the end faces 13 or a region including at least two or more of the end faces 13.

The total area of the end faces 13 included in the unit region, that is, the total area of the end faces 13 in the unit area is the first area S1. The total area of the reference plane 11A included in the unit region, that is, the total area of the reference plane 11A in the unit area is the second area S2. The ratio of the second area S2 to the first area S1 is an end face ratio S1/S2. S1/S2 satisfies:

$$S1/S2 \geq 0.2,$$

preferably satisfies:

$$S1/S2 \geq 0.4,$$

and more preferably satisfies:

$$S1/S2 \geq 1.0$$

from the viewpoint of enhancing the crystal growth of the compound semiconductor. That is, the first area S1 is preferably not less than the second area S2 as viewed in the direction facing toward the reference plane 11A. In a case where the end face ratio S1/S2 is not less than 1.0, the probability in which a crystal nucleus of the compound semiconductor reaches the end face 13 of the convexity 12 during formation of the compound semiconductor layer on the recessing and protruding face is greater than the probability in which the crystal nucleus reaches the reference plane 11A that is between the convexities 12 adjacent to each other. In particular, S1/S2 is preferably not less than 0.76 from the viewpoint of great increase in the light output of a semiconductor light-emitting element produced compared with a light-emitting element having a configuration in which S1/S2 is about 0.1.

When the crystal nucleus attached to the end face 13 of the convexity 12 has a mobility that does not allow the crystal nucleus to shift from the end faces 13 to the reference plane 11A, the growth of the crystal layer 31K constituting the compound semiconductor layer is likely to start on the end face 13 of the convexity 12. The crystal layer 31K of the compound semiconductor layer that has grown once from the end face 13 of convexity 12 functions as a barrier against the reference plane 11A, and inhibits the crystal nucleus of the compound semiconductor layer reaching the reference plane 11A.

As a result, the aggregation of the crystal layer 31K of the compound semiconductor layer grown from the end face 13 of the convexity 12 and the crystal layer 31K of the compound semiconductor layer grown from the reference plane 11A is suppressed. Therefore, coalescence growth of the crystal layers 31K that have grown from the end faces 13 of the convexities 12 adjacent to each other may be achieved, and a continuous compound semiconductor layer is likely to be formed. Accordingly, the crystal dislocation density in the compound semiconductor layer can be reduced.

The end face ratio S1/S2 is preferably not greater than 9.0. In a case where the end face ratio S1/S2 is not greater than 9.0, the size of the convexity 12 is likely to be adequate to promote the growth of a crystal from the end face 13. In particular, S1/S2 preferably satisfies a relationship $S1/S2 \leq 7.42$, from the viewpoint of great increase in the light output of a semiconductor light-emitting element produced compared with a light-emitting element having a configuration in which S1/S2 is about 0.1.

Thus, the range of the application of a method used in processing required to keep the end face ratio S1/S2 within a desired range may be expanded.

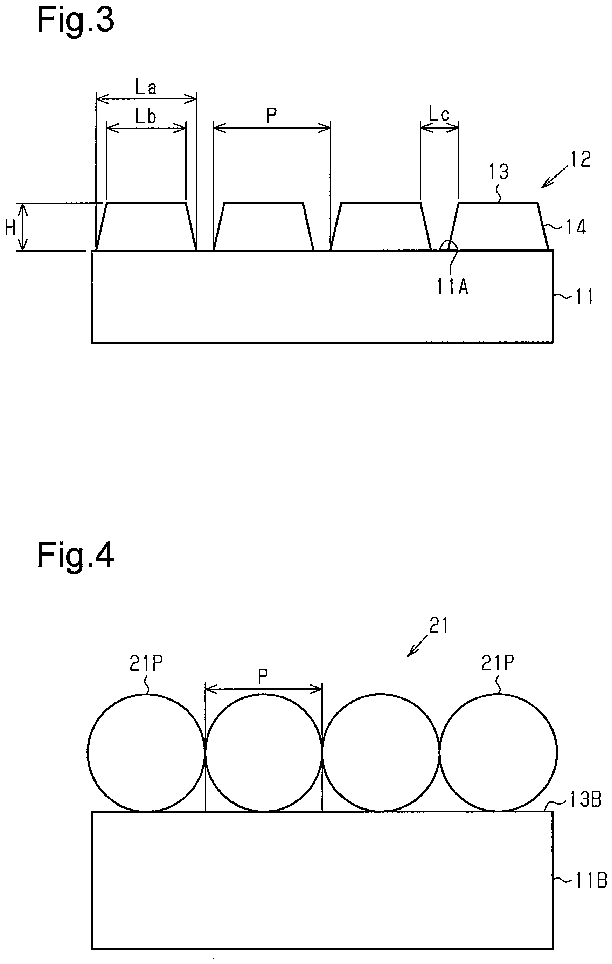

As illustrated in FIG. 3, the pitch of the convexities 12 adjacent to each other on the recessing and protruding face of the semiconductor light-emitting element substrate 11 is a convexity pitch P. The convexity pitch P is from 100 nm to 5.0 $\mu$m.

The convexity pitch P may be measured by any appropriate device. An atomic force microscope (AFM) or a scanning electron microscope (SEM) is preferably used in the measurement. For example, in a case of using an atomic force microscope, the convexity pitch P may be determined by image processing of obtained image of the recessing and protruding face. That is, an image of square region arbitrarily selected in the recessing and protruding face of the semiconductor light-emitting element substrate 11 is obtained by using the atomic force microscope. In this case, the length of side of the square region photographed by the atomic force microscope is, for example, from 30 times to 40 times the convexity pitch P that is predicted in advance. Subsequently, a Fast Fourier Transformed image based on the obtained image is obtained by waveform separation of the obtained image using Fast Fourier Transform. The distance between zeroth-order and first-order peaks in the Fast Fourier Transformed image is then determined. The reciprocal of the distance is given as a measured value in one square region. In 25 or more square regions that are different from each other, such measured values are obtained. The average value of the measured values obtained from all the 25 samples, that is, the mode of the measured values is given as the convexity pitch P. The distance between square regions adjacent to each other, among the 25 square regions, is preferably at least 1 mm, and more preferably from 5 mm to 1 cm. In a case of using a scanning electron microscope, the distance between centers of adjacent convexities in a surface shape image of the recessing and protruding face is measured. The distances in convexities randomly selected are measured, and the average value of the measured distances in 50 or more convexities is calculated and treated as the convexity pitch P.

In a case where the convexity pitch P is not less than 100 nm, the size of the convexities 12 is likely to be sufficient to promote the growth of a crystal from the end face 13. Accordingly, the range of the application of a method used in processing required to keep the end face ratio S1/S2 within a desired range may be expanded.

When the convexity pitch P is not greater than 5.0 $\mu$m, the first area S1 is excessively large. This suppresses nonuniform distribution of the crystal layer 31K in each of the end faces 13. Therefore, in a case where the end faces 13 are substantially uniformly dispersed, uniform distribution of positions of the crystal layers 31K constituting the compound semiconductor layer in the recessing and protruding face is likely to be achieved.

In a case where the recessing and protruding face of the semiconductor light-emitting element substrate 11 is a simple flat face parallel to the crystal plane, that is, the convexity 12 projected from the reference plane 11A is absent in the reference plane 11A, a position of the crystal layers 31K constituting the compound semiconductor layer is irregularity distributed in the entire flat face.

In the semiconductor light-emitting element substrate 11 described above, the end faces 13 are repeated at the convexity pitch P from 100 nm to 5.0 $\mu$m. Therefore, nonuniform distribution of positions of the crystal layers 31K constituting the compound semiconductor layer in the recessing and protruding face, that is, nonuniform distribution of crystal dislocation density in the compound semiconductor layer in the recessing and protruding face is also suppressed. In other words, the reference plane 11A of the semiconductor light-emitting element substrate 11 described above has a function of enhancing uniformity of the crystal layer 31K that grow from each of the end faces 13.

The maximum width of the base of the convexity 12 is a base width La. The distance between the reference plane 11A and the end face 13 in the projection direction of the convexity 12 is a convexity height H. The aspect ratio H/La, which is obtained by dividing the convexity height H by the base width La, preferably satisfies a relationship $0.01 \leq H/La \leq 1.0$.

The base width La may be measured by any appropriate device, as in the measurement of the convexity pitch P. An atomic force microscope (AFM) or a scanning electron microscope (SEM) is preferably used in the measurement. For example, in a case of using an atomic force microscope, the convexity pitch P may be determined by image processing of obtained image of the recessing and protruding face. In a case of using a scanning electron microscope, the base width La in each of the convexities randomly selected is measured in the surface shape image of the recessing and protruding face, and the average value of the measured values in 50 or more convexities is calculated and given as the base width La. The convexity height H may be determined by image processing of an obtained image of the recessing and protruding face by the atomic force microscope. For example, an image of square region arbitrarily selected in the recessing and protruding face of the semiconductor light-emitting element substrate 11 is obtained by using the atomic force microscope. From the image obtained by the atomic force microscope, the cross-sectional shape of the recessing and protruding face is obtained. Subsequently, differences between the heights of the end faces 13 of the convexity 12 in five or more consecutive convexities 12 in the cross-sectional shape and the height of crystal plane in the reference plane 11A are obtained as measured values. In five or more square regions that are different from each other, the measured values are obtained, and thus, in all, 25 or more measured values are obtained. An equatorial profile is produced from a two-dimensional Fast Fourier Transformed image, and the mode of the convexity height H is obtained from the reciprocal of first-order peak in the profile, and given as the convexity height H. In a case of using a scanning electron microscope, the height H of each of the convexities randomly selected is measured in a cross-sectional shape image of the recessing and protruding face, and the average value of the measured values in 50 or more convexities is calculated and given as the convexity height H.

In a case where the aspect ratio H/La is not less than 0.01, the aggregation of the crystal layer 31K of the compound semiconductor layer that grows from the end face 13 and the crystal layer 31K of the compound semiconductor layer that grows from the reference plane 11A is likely to be suppressed. In a case where the aspect ratio H/La is not greater than 1.0, the semiconductor light-emitting element substrate is easily processed to form a concavity between the convexities 12 adjacent to each other. In a case where the convexity height H is not less than 100 nm, difference in level between the end face 13 of the convexity 12 and the reference plane 11A is made clear in terms of controlling coalescence growth of the crystal layer 31K that grow from the end face 13. In a case where the convexity height H is not greater than 5.0 μm, the load on processing required for formation of the concavities between the convexities 12 adjacent to each other is reduced.

The maximum width of the end face 13 in a direction in which the end face 13 extends is an end width Lb. The distance between the convexities 12 adjacent to each other is a gap width Lc between the convexities 12.

From the viewpoint that the first area S1 of the end faces 13 included in the unit area can be increased, the end width Lb is preferably large and the difference between the base width La and the end width Lb is preferably small. The difference between the base width La and the convexity pitch P is preferably small from the viewpoint that S1 and S2 is likely to satisfy a relationship for the end face ratio, S1/S2 ≥ 0.76. From the viewpoint of promoting crystal growth, the end width ratio Lb/P obtained by dividing the end width Lb by the convexity pitch P is preferably not less than 0.5. The end width Lb may be measured by any appropriate device, as in the measurement of the convexity pitch P. An atomic force microscope (AFM) or a scanning electron microscope (SEM) is preferably used in the measurement. For example, in a case of using an atomic force microscope, the convexity pitch P may be determined by image processing of obtained image of the recessing and protruding face. In a case of using a scanning electron microscope, the end width Lb in each of the convexities randomly selected is measured in the surface shape image of the recessing and protruding face, and the average value of the measured values in 50 or more convexities is calculated and given as the end width Lb.

Method for Manufacturing Semiconductor Light-Emitting Element Substrate

A method for manufacturing the semiconductor light-emitting element substrate 11 will be described hereinafter.

The method for manufacturing the semiconductor light-emitting element substrate 11 includes forming a mask 21 on a substrate 11B that is a substrate of the semiconductor light-emitting element substrate 11, and etching the substrate using the mask 21. FIGS. 4 to 6 illustrate an example of a manufacturing method using a particle monolayer as the mask 21.

As illustrated in FIG. 4, the substrate 11B constitutes the material constituting the semiconductor light-emitting element substrate 11, and includes a treatment face 13B that is a flat face parallel to the crystal plane of the material constituting the substrate 11B. The mask 21 formed on the treatment face 13B is a particle monolayer that is an assembly of particles 21P arranged in layers. The particle diameter of particles 21P constituting the particle monolayer is substantially equal to the convexity pitch P.

The particles 21P constituting the particle monolayer are one or more kinds of particles selected from the group consisting of organic particles, organic-inorganic composite particles, and inorganic particles. A material forming organic particles is, for example, one selected from the group consisting of diamond, graphite, and fullerene. A material forming organic-inorganic composite particles is, for example, one selected from the group consisting of SiC and boron carbide.

The particles 21P are preferably inorganic particles. In a case where the particles 21P are inorganic particles, the selective etching ratio of the particle monolayer to the treatment face 13B is likely to be obtained in a step of selective etching of the particle monolayer formed from the particles 21P. A material forming inorganic particles is, for example, one selected from the group consisting of an inorganic oxide, an inorganic nitride, an inorganic boride, an inorganic sulfide, an inorganic selenide, a metal compound, and a metal.

As a method for forming the particle monolayer, any one of a Langmuir-Blodgett method (LB method), a particle adsorption method, or a binder layer fixation method is used. In the LB method, a dispersion liquid in which particles are dispersed in a solvent having a specific gravity lower than water is used, and the dispersion liquid is added dropwise to a liquid surface of water. The solvent is then volatilized from the dispersion liquid to form the particle monolayer formed from the particles on a liquid surface. The particle monolayer formed on the liquid surface is transferred to the treatment face 13B, to form the particle monolayer that is the mask 21.

In the particle adsorption method, the substrate 11B is immersed in a suspension liquid of colloidal particles. Particles on second or higher-order layers are removed so that only a particle layer of a first layer that is electrostatically bonded to the treatment face 13B remains. As a result, the particle monolayer is formed on the treatment face 13B. In the binder layer fixation method, a binder layer is formed on the treatment face 13B, and a dispersion liquid of particles is applied to the binder layer. The binder layer is then heated and softened, only a particle layer of a first layer is embedded in the binder layer, and particles on second or higher-order layers are rinsed out. As a result, the particle monolayer is formed on the treatment face 13B.

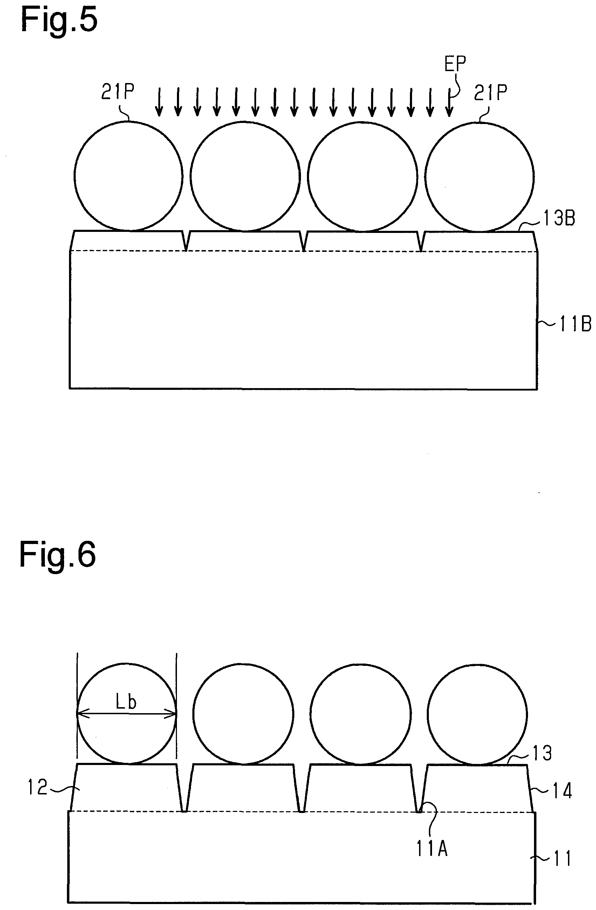

As illustrated in FIG. 5, etching of the particles 21P in the mask 21 formed on the treatment face 13B of the substrate 11B proceeds initially. The etching reduces the particle diameter of the particles 21P constituting the mask 21, and forms a new gap between the particles 21P adjacent to each other.

The new gap is formed between the particles in the mask 21, then the treatment face 13B is etched by using the particles 21P as a mask, wherein the particles 21P has a reduced particle diameter. At that time, the treatment face 13B is exposed to an etching gas EP that is an etchant through the gap between the particles 21P adjacent to each other, and the particles 21P constituting the mask 21 is also exposed to the etching gas EP that is the etchant. In the treatment face 13B, etching at a portion opposite to the periphery of the particles 21P preferentially proceeds compared with at a portion opposite to the particles 21P.

As illustrated in FIG. 6, etching of the treatment face 13B is terminated when the diameters of the particles 21P are substantially equal to the end width Lb. As a result, the portion opposite to the particles 21P in the treatment face 13B is a flat face in which the crystal plane of the treatment face 13B is preserved. This portion is the end face 13. That is, a periphery of the end face 13 is a face processed by etching, and includes a new crystal plane that has the same Miller indices as those of the treatment face 13B. Therefore, the plurality of convexities 12 that have a truncated cone shape and include the end faces 13 are formed and partitioned by the reference plane 11A.

In a method using the particle monolayer as the mask 21, changing the particle diameter of the particles 21P can change the convexity pitch P easily. This is because the convexity pitch P is equal to the diameter of the particles 21P. Changing etching conditions such as a pressure, an applied electric power, an etching gas ratio, an etching gas flow rate, and an etching time can change the end face ratio S1/S2, the end width ratio Lb/P, and the aspect ratio H/La.

Semiconductor Light-Emitting Element

Next, a semiconductor light-emitting element produced by using the semiconductor light-emitting element substrate 11, and a method for producing the same will be described.

The light-emitting element has the semiconductor light-emitting element substrate 11 as a substrate. The light-emitting element has a light-emitting device on the recessing and protruding face of the semiconductor light-emitting element substrate 11. The light-emitting device is a multi-layered body including a plurality of compound semiconductor layers. An electric current is supplied to the light-emitting device, resulting in recombination of carriers, and light is emitted. The light-emitting device includes a buffer layer that grows at a temperature lower than the temperature at which a light-emitting layer that is one of the compound semiconductor layers is formed. The buffer layer is the crystal layer 31K that grows from the end face 13, and has a function of imparting the crystallinity of the end face 13 to the semiconductor layers except for the buffer layer.

The function of the light-emitting device includes n-type conductivity, p-type conductivity, and an activity of resulting in recombination of carriers. A layer structure in the light-emitting device may be a heterostructure in which an active layer is disposed between an n-type semiconductor layer and a p-type semiconductor layer, or a multiple quantum well structure in which a plurality of quantum well structures are layered. Materials constituting the compound semiconductor layers are preferably compound semiconductors such as AlN, InGaN, AlGaN, and InAlGaN.

A method for manufacturing the light-emitting structure includes manufacturing the semiconductor light-emitting element substrate 11 by the method for manufacturing the semiconductor light-emitting element substrate describe above, and forming the light-emitting structure on the recessing and protruding face of the semiconductor light-emitting element substrate 11.

A method for forming each compound semiconductor layer may be an epitaxial growth method such as a molecular beam epitaxy method and a gas-phase epitaxy method or a MOVPE method (MOCVD method) from the viewpoint of productivity and structure control. A method for forming the n-type semiconductor layer may be an epitaxial growth method in which an n-type impurity is added. A method for forming the p-type semiconductor layer may be an epitaxial growth method in which a p-type impurity is added.

For example, in a molecular beam epitaxial growth method, molecules or atoms of constituent elements of the compound semiconductor layers are allowed to reach the recessing and protruding face of the semiconductor light-emitting element substrate 11, and crystals of the material constituting the compound semiconductor layers are grown on the recessing and protruding face.

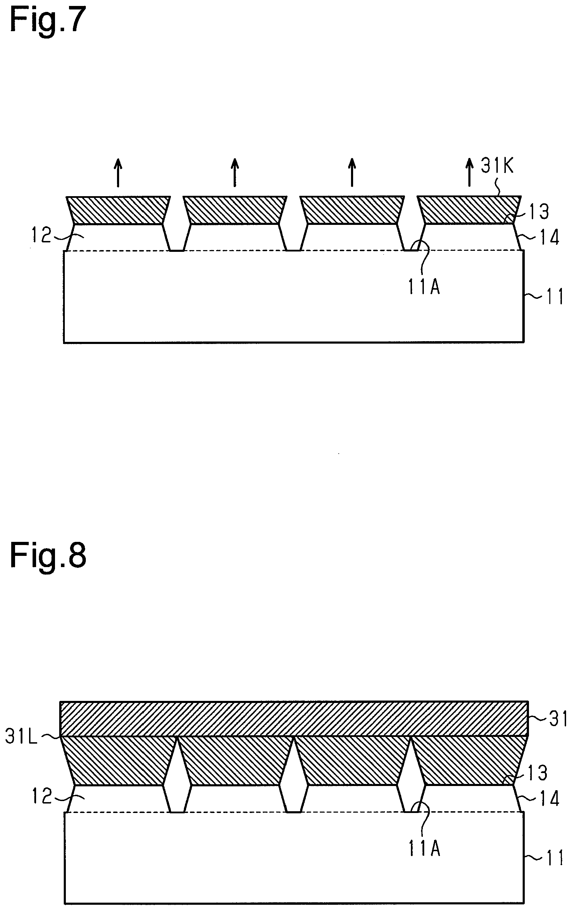

In this case, the end face ratio S1/S2 in the semiconductor light-emitting element substrate 11 is not less than 0.2, as illustrated in FIG. 7. Therefore, the probability in which a crystal nucleus of the compound semiconductor reaches the end face 13 of convexity 12 is higher than the probability in which the crystal nucleus reaches the reference plane 11A that is between the convexities 12 adjacent to each other, compared with a case where an end face ratio S1/S2 is less than 0.2. Particularly, in a case where S1/S2 satisfies a relationship $0.76 \leq S1/S2 \leq 7.42$, such a probability can be sufficiently reflected in enhancement of crystallinity, compared with a case where S1/S2 is about 0.1.

In a case where the nucleus attached to the end face 13 of convexity 12 has a mobility that does not allow the nucleus to move from the end face 13 to the reference plane 11A, the growth of the crystal layer 31K constituting the compound semiconductor layer is likely to start on the end face 13 of convexity 12, but not on the reference plane 11A.

The crystal layer 31K of the compound semiconductor layer grown from the end face 13 of convexity 12 grows from the end face 13 in an inverted frustum shape. The crystal layer 31K grown from the end face 13 functions as a barrier on the reference plane 11A against the crystal of compound semiconductor that is formed toward the recessing and protruding face, and suppresses attachment of the crystal nucleus of the compound semiconductor to the reference plane 11A.

As a result, the aggregation of the crystal layer 31K of the compound semiconductor layer grown from the end face 13 of the convexity 12 and the crystal layer 31K of the compound semiconductor layer grown from the reference plane 11A are suppressed, as illustrated in FIG. 8. Due to coalescence growth of the crystal layers 31K grown from the end face 13 of the convexities 12 adjacent to each other, a position 31L where the crystal layers are aggregated is formed. A continuous compound semiconductor layer 31 is likely to be formed from only the crystal layer 31K grown from the end face 13.

The layer growth of compound semiconductor at the gap between the convexities 12 adjacent to each other is suppressed, and thus the gap between the convexities 12 adjacent to each other is formed as a hole. From the viewpoint of suppressing excessive increase in volume of the hole, the distance between the end faces 13 and the position 31L where the crystal layers are aggregated is preferably short. Specifically, the end face ratio S1/S2 is preferably large and the end width ratio Lb/P is preferably not less than 0.5.

Example 1

As a substrate 11B, a sapphire substrate having a diameter of 2 inches, a thickness of 0.43 mm, and a c-plane that was a crystal plane of a treatment face 13B was used. As particles 21P, colloidal silica particles having an average particle diameter of 2.0 μm were used. A particle monolayer that was a mask 21 was formed on a treatment face 13B by a monolayer coating method. Subsequently, the treatment face 13B having the mask 21 was subjected to plasma etching using a $BCl_3$ gas as an etching gas for 400 seconds, to form convexity 12. As a result, a semiconductor light-emitting element substrate 11 of Example 1 having the following parameters was obtained.

| | |
|---|---|
| End face ratio S1/S2 | :2.8 |
| Convexity pitch P | :2.0 μm |
| Base width La | :1.9 μm |
| End width Lb | :1.5 μm |
| Gap width Lc | :0.5 μm |
| Aspect ratio H/La | :0.21 |
| End width ratio Lb/P | :0.75 |

Example 2

A semiconductor light-emitting element substrate 11 of Example 2 having the following parameters was obtained by the same treatment as in Example 1 except that as particles 21P, colloidal silica particles having an average particle diameter of 4.0 μm were used, the etching time was changed to 1000 seconds, and the applied electric power was reduced.

| | |
|---|---|
| End face ratio S1/S2 | :7.42 |
| Convexity pitch P | :4.0 μm |
| Base width La | :4.0 μm |
| End width Lb | :3.5 μm |
| Gap width Lc | :0.0 μm |
| Aspect ratio H/La | :0.23 |
| End width ratio Lb/P | :0.88 |

Example 3

A semiconductor light-emitting element substrate 11 of Example 3 having the following parameters was obtained by the same treatment as in Example 1 except that as particles 21P, colloidal silica particles having an average particle diameter of 600 nm were used, the etching time was changed to 300 seconds, and the applied electric power was reduced.

| | |
|---|---|
| End face ratio S1/S2 | :2.09 |
| Convexity pitch P | :600 nm |
| Base width La | :595 nm |
| End width Lb | :300 nm |
| Gap width Lc | :300 nm |
| Aspect ratio H/La | :0.42 |
| End width ratio Lb/P | :0.50 |

Example 4

A semiconductor light-emitting element substrate 11 of Example 4 having the following parameters was obtained by the same treatment as in Example 1 except that as particles 21P, colloidal silica particles having an average particle diameter of 2.0 $\mu$m were used, the etching time was changed to 560 seconds, and a mixed gas of $BCl_3$ and $Cl_2$ was used.

| | |
|---|---|
| End face ratio S1/S2 | :0.76 |
| Convexity pitch P | :2.0 $\mu$m |
| Base width La | :1.76 $\mu$m |
| End width Lb | :1.0 $\mu$m |
| Gap width Lc | :1.0 $\mu$m |
| Aspect ratio H/La | :0.40 |
| End width ratio Lb/P | :0.50 |

Reference Example

A semiconductor light-emitting element substrate 11 of Reference Example having the following parameters was obtained by the same treatment as in Example 1 except that as particles 21P, colloidal silica particles having an average particle diameter of 2.0 $\mu$m were used and the etching time was changed to 1000 seconds.

| | |
|---|---|
| End face ratio S1/S2 | :0.13 |
| Convexity pitch P | :2.0 $\mu$m |
| Base width La | :1.6 $\mu$m |
| End width Lb | :0.5 $\mu$m |
| Gap width Lc | :1.5 $\mu$m |
| Aspect ratio H/La | :0.30 |
| End width ratio Lb/P | :0.25 |

An AlN layer having a thickness of 13.0 $\mu$m was formed as an example of a compound semiconductor layer on each of the substrates having a recessing and protruding face produced in Examples 1 to 4 and Reference Example and a flat substrate having no recessing and protruding face as a Comparative Example by an MOCVD method in which the substrate was heated to 1200°C and a source gas was thermally decomposed. Each AlN layer was subjected to rocking curve measurement using an X-ray diffraction method. As a result, the half width with respect to a (10-12) face was confirmed to exhibit a decrease by 20.6% in Example 1, by 28.1% in Example 2, and by 6.7% in Example 4, compared with the substrate having no recessing and protruding face. The half width with respect to the (10-12) face was confirmed to exhibit a decrease by 25.3% in Example 1, by 32.4% in Example 2, by 3.7% in Example 3, and by 12.3% in Example 4, compared with Reference Example in which the end face ratio S1/S2 is small. That is, in all Examples in which S1/S2 satisfies a relationship $0.76 \leq S1/S2 \leq 7.42$, a decrease in crystal dislocation density was confirmed compared with Reference Example in which the end face ratio S1/S2 is 0.13.

An n-type semiconductor layer, an active layer, and a p-type semiconductor layer were successively layered and a p-type electrode and an n-type electrode were formed, to manufacture a semiconductor light-emitting element. In this case, the light-emitting efficiency in Example 1 was 10.1%. The 26.3% increase in light-emitting efficiency compared with the substrate having no recessing and protruding face was confirmed. The light-emitting efficiency in Example 2 was 8.3%. The 3.8% increase in light-emitting efficiency compared with the substrate having no recessing and protruding face was confirmed. The light-emitting efficiency in Example 3 was 9.1%. The 13.8% increase in light-emitting efficiency compared with the substrate having no recessing and protruding face. The light-emitting efficiency in Example 4 was 8.2%. The 2.5% increase in light-emitting efficiency compared with the substrate having no recessing and protruding face was confirmed. The 110.4% increase in light output in Example 1 was confirmed, the 72.9% increase in light output in Example 2 was confirmed, the 89.6% increase in light output in Example 3 was confirmed, and the 70.8% increase in light output in Example 4 was confirmed, compared with Reference Example in which the light-emitting efficiency was 4.8%. That is, in all Examples in which S1/S2 satisfies a relationship $0.76 \leq S1/S2 \leq 7.42$, an increase in light output greater than 70% was confirmed, compared with Reference Example in which the end face ratio S1/S2 is 0.13.

According the embodiment described above, the following effects are obtained.

(1) In a case where the total area of the end faces 13 of the convexities 12 is greater than the total area of the reference plane 11A, or in a case where the total area of the end faces 13 is smaller than the total area of the reference plane 11A and the convexities 12 have a certain height, the aggregation of the crystal layer 31K of the compound semiconductor layer grown from the end faces 13 of the convexities 12 and the crystal layer 31K of the compound semiconductor layer grown from the reference plane 11A in formation of the compound semiconductor layer is suppressed. The coalescence growth of the crystal layers 31K grown from the end faces 13 of the convexities 12 adjacent to each other and the formation of continuous compound semiconductor layer are achieved. Therefore, the crystal dislocation density in the compound semiconductor layer can be reduced.

(2) The pitch between the convexities 12 repeatedly arranged is from 100 nm to 5.0 $\mu$m, and thus the nonuniform arrangement of position of the crystal layer 31K constituting the compound semiconductor layer is suppressed. Consequently, the nonuniform distribution of crystal dislocation density is also suppressed due to the coalescence growth of the crystal layers 31K.

(3) The end width ratio Lb/P satisfies a relationship $0.5 \leq$ Lb/P, and thus the coalescence growth of the crystal layers 31K grown from the end faces 13 of the convexities 12 adjacent to each other and the formation of continuous compound semiconductor layer are likely to be achieved.

(4) The aspect ratio H/La is not less than 0.01, and thus the aggregation between the crystal layer 31K of the compound semiconductor layer grown from the end face 13 of the convexity 12 and the crystal layer of the compound semiconductor layer grown from the reference plane 11A is more certainly suppressed.

(5) The aspect ratio H/La is not greater than 1.0, and thus a load on processing in which the convexity height H is set to an unnecessarily large value or the second area S2 is set to an unnecessarily small value is also suppressed.

(6) The convexities 12 has a frustum shape, and thus a region where the reference plane 11A supporting the convexities 12 are connected to the base of the convexity 12 is greater compared with a case where the convexity 12 has a columnar or inverted frustum shape. Therefore, the convexities 12 can be structurally stabilized.

(7) The particle monolayer is used as the mask 21, and thus exposure for formation of the mask 21 and development for formation of the mask can be omitted from a manufacturing process. Therefore, the number of processes of treatments for the substrate 11B can be decreased.

The embodiments can be performed with modifications as described below.

• Within the plurality of convexities 12, a portion of the base of convexity 12 may be connected to a portion of the base of another convexity 12.

• A mask formed on the treatment face 13B is not limited to the particle monolayer. For example, the mask may be a resist mask formed by a photolithographic method or a hard mask formed by combination of various types of film forming methods and a photolithographic method.

• A portion other than the crystal plane of the reference plane 11A may have a step or a curvature formed by etching.

Reference Signs List

H Convexity height
La Base width
Lb End width
Lc Gap width
H/La Aspect ratio
P Convexity pitch
S1 First area
S2 Second area
S1/S2 End face ratio
11 Semiconductor light-emitting element substrate
11A Reference plane
11B Substrate
12 Convexity
13 End face
14 Circumferential face
21 Mask
21P Particles
31 Compound semiconductor layer
31K Crystal layer
31L Position where crystal layers are associated

**Claims**

1. A semiconductor light-emitting element substrate comprising a reference plane including a flat face parallel to a crystal plane of a material constituting the semiconductor light-emitting element substrate, and a plurality of convexities projected from the reference plane, the plurality of convexities being arranged on a two-dimensional lattice along the crystal plane and a convexity within the plurality of convexities having a flat face parallel to the crystal plane as an end face,
wherein the plurality of convexities adjacent to each other are disposed on a plane including the reference plane at a pitch P of from 100 nm to 5.0 $\mu$m, and a relationship:

$$0.76 \leq S1/S2 \leq 7.42$$

is satisfied where a first area S1 is a total area of a plurality of the end faces in a unit area in a plan view facing toward the reference plane, and a second area S2 is a total area of the reference plane in the unit area.

2. The semiconductor light-emitting element substrate according to claim 1, wherein a maximum width of the end face in a direction parallel to the end face is an end width Lb, and the end width Lb and the pitch P satisfy a relationship:

$$0.50 \leq Lb/P \leq 0.88.$$

3. The semiconductor light-emitting element substrate according to claim 1 or 2, wherein a maximum width of a base of the convexity in a direction parallel to the end face is a base width La, and a distance between the base and the end face in a projection direction of the convexity is a convexity height H, and La and H satisfy a relationship:

$$0.01 \leq H/La \leq 1.0.$$

4. The semiconductor light-emitting element substrate according to any one of claims 1 to 3, wherein the convexity has a frustum shape.

5. A method for manufacturing a semiconductor light-emitting element substrate comprising:

forming a mask on a treatment face, the treatment face being a flat face parallel to a crystal plane of a material constituting the substrate and being included in the substrate; and
forming a plurality of convexities and a reference plane on the substrate by etching the treatment face using the mask,
wherein a convexity within the plurality of convexities has a flat face as an end face, the flat surface being a portion of the treatment face covered with the mask,
the plurality of convexities are arranged on a two-dimensional lattice along the crystal plane, the reference plane being a bottom face in a concavity that is a gap between the convexities adjacent to each other and including a flat face parallel to the crystal plane,
the plurality of convexities adjacent to each other are disposed on a plane including the reference plane at a pitch P of from 100 nm to 5.0 $\mu$m, and in the forming the plurality of convexities and the reference plane, a relationship:

$$0.76 \leq S1/S2 \leq 7.42$$

is satisfied where a first area S1 is a total area of a plurality of the end faces in a unit area in a plan view facing toward the reference plane, and a second area S2 is a total area of the reference plane in the unit area.

6. The method for manufacturing a semiconductor light-emitting element substrate according to claim 5, wherein in the forming the mask, the mask is a particle monolayer, and the particle monolayer includes a plurality of fine particles arranged in a layer and is formed on the treatment face.

## Fig.1

## Fig.2

Fig.3

Fig.4

# Fig.5

# Fig.6

# Fig.7

# Fig.8

**INTERNATIONAL SEARCH REPORT**

| International application No. |
|---|
| PCT/JP2017/001601 |

A. CLASSIFICATION OF SUBJECT MATTER
*H01L33/22*(2010.01)i, *C30B25/04*(2006.01)i, *H01L21/203*(2006.01)i,
*H01L21/205*(2006.01)i

According to International Patent Classification (IPC) or to both national classification and IPC

B. FIELDS SEARCHED

Minimum documentation searched (classification system followed by classification symbols)
H01L33/00-33/64, H01L21/203, H01L21/205

Documentation searched other than minimum documentation to the extent that such documents are included in the fields searched
Jitsuyo Shinan Koho        1922-1996    Jitsuyo Shinan Toroku Koho    1996-2017
Kokai Jitsuyo Shinan Koho    1971-2017    Toroku Jitsuyo Shinan Koho    1994-2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2012-244091 A (Toshiba Corp.),<br>10 December 2012 (10.12.2012),<br>entire text; all drawings<br>& US 2012/0299014 A1    & US 2014/0319460 A1<br>& US 2015/0236200 A1 | 1-6 |
| A | JP 2014-175601 A (Toyoda Gosei Co., Ltd.),<br>22 September 2014 (22.09.2014),<br>entire text; all drawings<br>& US 2014/0264415 A1    & CN 104051590 A<br>& KR 10-2014-0111967 A  & TW 201436281 A | 1-6 |
| A | JP 2011-238884 A (Mitsubishi Chemical Corp.),<br>24 November 2011 (24.11.2011),<br>entire text; all drawings<br>(Family: none) | 1-6 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 March 2017 (09.03.17) | 28 March 2017 (28.03.17) |

| Name and mailing address of the ISA/<br>Japan Patent Office<br>3-4-3,Kasumigaseki,Chiyoda-ku,<br>Tokyo 100-8915,Japan | Authorized officer<br><br><br>Telephone No. |
|---|---|

Form PCT/ISA/210 (second sheet) (January 2015)

**INTERNATIONAL SEARCH REPORT**

International application No.

PCT/JP2017/001601

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2011/105557 A1  (Kyocera Corp.),<br>01 September 2011 (01.09.2011),<br>entire text; all drawings<br>(Family: none) | 1-6 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002280611 A
- JP 2003318441 A
- JP 2012248874 A